# EUROPÄISCHE PATENTSCHRIFT

(11) **EP 1 425 831 B1**
(45) Veröffentlichungstag und Bekanntmachung des Hinweises auf die Patenterteilung: **08.06.2005**
(21) Anmeldenummer: 01274582.4
(22) Anmeldetag: 21.11.2001
(51) Int. Cl.: H01S 5/042

(54) **INTEGRIERTER SCHALTKREIS ZUR ANSTEUERUNG EINER LASERDIODE**
INTEGRATED CIRCUIT FOR CONTROLLING A LASER DIODE
CIRCUIT DE COMMUTATION INTEGRE POUR EXCITER UNE DIODE LASER

(30) Priorität: 14.09.2001 WO PCT/DE20/10003606; 02.11.2001 WO PCT/DE20/10004175
(43) Veröffentlichungstag der Anmeldung: 09.06.2004
(73) Patentinhaber: Infineon Technologies AG, 81669 München (DE)
(72) Erfinder: SCHRÖDINGER, Karl, 14089 Berlin (DE); OHEIM, Toralf, 16761 Henningsdorf (DE)
(74) Vertreter: Fischer, Uwe
(86) Internationale Anmeldenummer: PCT/DE2001/004423
(87) Internationale Veröffentlichungsnummer: WO 2003/036770

(56) Entgegenhaltungen:
- DE-A- 1 614 820
- US-A- 5 471 492
- US-A- 5 539 761
- US-A- 5 784 091
- US-A- 5 883 910
- PATENT ABSTRACTS OF JAPAN vol. 008, no. 161 (E-257), 26. Juli 1984 (1984-07-26) & JP 59 061193 A (FUJITSU KK), 7. April 1984 (1984-04-07)

## Beschreibung

Die vorliegende Erfindung betrifft einen integrierten Schaltkreis zur Ansteuerung einer Laserdiode, einen integrierten Schaltkreis zur differentiellen Ansteuerung einer Laserdiode, sowie einen integrierten Schaltkreis zur Ansteuerung eines Laserdioden-Arrays mit einer Vielzahl von Laserdioden.

Um möglichst kleine Verlustleistungen zu erreichen, werden integrierte Schalkreise (ICs) zur Ansteuerung von Laserdioden für immer kleiner werdende Versorgungsspannungen entwickelt. Eine weitere Motivation für kleinere Versorgungsspannungen sind Durchbruchkriterien mancher der verwendeten integrierten Bauteile. US-A-5 784 091 offenbart einen solchen Schaltkreis.

Der Arbeitspunkt der anzusteuernden Laserdiode wird durch einen Schwellstrom und einen Modulationsstrom eingestellt, wobei der Modulationsstrom den Datenstrom darstellt. Die Ströme erzeugen einen Spannungsabfall an der Laserdiode. Der Spannungsabfall an der Diode kann so gross sein, dass der Laser aufgrund der begrenzenden Versorgungsspannung vom Lasertreiber-IC nicht mehr direkt getrieben werden kann.

Ist der Spannungsabfall an der Laserdiode so gross, dass der Laser aufgrund der begrenzten Versorgungsspannung bzw. der notwendigen Spannungsabfälle an den Treibertransistoren vom Lasertreiber-IC nicht mehr direkt getrieben werden kann, so ist es bekannt, die Modulation der Laserdiode mittels einer Koppelkapazität erfolgen zu lassen. Bei der Modulation und Übertragung der Daten im Hochfrequenzbereich treten jedoch an den Koppelstrecken sowohl vom Modulationsausgang des Lasertreiber-ICs zum Koppelkondensator als auch vom Koppelkondensator zur Laserdiodenkoppeleinheit Verluste und Fehlanpassungen durch parasitäre Elemente auf. Diese parasitären Elemente können unter anderem Bonddrahtinduktivitäten und Padkapazitäten sein.

Die vorliegende Erfindung hat die Aufgabe, diese Nachteile zumindest abzumindern. Dieser Aufgabe wird durch die in den unabhängigen Ansprüchen angegebene Erfindung gelöst. Vorteilhafte Ausgestaltungen der Erfindung sind den Unteransprüchen zu entnehmen.

Erfindungsgemäss ist ein integrierter Schaltkreis zur Ansteuerung einer Laserdiode geschaffen, mit: einem Signaleingang zum Empfang eines Datensignales; einem Signalausgang zum Anschluss an die Laserdiode; einem Modulator zur Modulation des Datensignales; einer mit dem Signalausgang verbundenen Stromeinspeisung zur Biasstromzufuhr; und einem Koppelkondensator zwischen dem Ausgang des Modulators und dem Signalausgang, zur Bildung eines Hochpasses mit dem Widerstand der and den Signalausgang angeschlossenen Laserdiode.

Durch Integration der Koppelkapazität in den Lasertreiber-IC wird die Anzahl der problematischen Koppelstrecken vom Modulationsausgang des Lasertreiber-ICs zur Laserdiodenkoppeleinheit verkleinert. Somit entfällt die erste Koppelstrecke zwischen dem Modulationsausgang des Lasertreiber-ICs und externer Koppelkapazität. Dieser Vorteil kann für eine einfache als auch eine differentielle Ansteuerung der Laserdiode genutzt werden.

In einer Ausgestaltung weist der integrierte Schaltkreis eine aktive Kompensationsschaltung auf, mit einem mit dem Ausgang des Modulators verbundenen Tiefpass und einer mit dem Tiefpass verbundenen Schaltung zur Erzeugung eines zur Tiefpassausgangsspannung umgekehrt proportionalen Signales. Diese Schaltung ist derart mit dem Signalausgang verbunden, dass das zur Tiefpassausgangsspannung umgekehrt proportionale Signal von dem Ausgangssignal abgezogen wird. Der Tiefpass kann von einer das Datensignal führenden Schaltung angesteuerbar sein.

In einer Ausgestaltung weist der integrierte Schaltkreis eine aktive Kompensationsschaltung auf, mit einem mit dem Ausgang des Modulators verbundenen Tiefpass und einer mit dem Tiefpass verbundenen Schaltung zur Erzeugung eines zur Tiefpassausgangsspannung proportionalen Signales. Diese Schaltung ist derart mit dem Signalausgang verbunden, dass das zur Tiefpassausgangsspannung proportionale Signal zum Ausgangssignal hinzuaddiert wird. Der Tiefpass kann von einer das Datensignal führenden Schaltung angesteuerbar sein.

In einer anderen Ausgestaltung umfasst der integrierte Schaltkreis eine aktive Kompensationsschaltung mit: einem mit dem Ausgang des Modulators verbundenen Tiefpass; einem mit dem Tiefpass verbundenen Spannungsinverter, zur Negierung der durch den Tiefpass entsprechend der Tiefpassübertragungsfunktion erzeugten Spannung; einen mit dem Ausgang des Spannungsinverters verbundenen Spannungsfolger; und einem Wandler zwischen dem Ausgang des Spannungsfolgers und dem Signalausgang, zur Erzeugung eines zur Tiefpassausgangsspannung umgekehrt proportionalen Stromes.

Diese Ausgestaltung hat den folgenden Vorteil: Die Koppelkapazität bildet mit dem differentiellen Widerstand der Laserdiode einen Hochpass. Für eine breitbandige Datenübertragung sind dabei möglichst grosse Zeitkonstanten erforderlich. Durch die Festlegung der Zeitkonstante des Hochpasses wird die untere Bandbreitenbegrenzung bestimmt. Da der differentielle Widerstand der Laserdiode vorgegeben ist, muss der Wert der Koppelkapazität dementsprechend gross gewählt werden. Grosse Kapazitäten in ICs nehmen jedoch entsprechend der Flächenkapazität grosse Flächen auf ICs ein, und können eine schädliche Kapazität zum Subtstrat (Masse) haben.

Die aktive Kompensationsschaltung ermöglicht es nun, die integrierte Kapazität bei gleichbleibender unterer Bandbreitenbegrenzung verkleinern zu können. Anders ausgedrückt wird durch die Anwendung der Kompensationsschaltung bei gleichbleibender integrierter Kapazität die untere Bandbreitenbegrenzung erweitert.

Erfindungsgemäss ist ausserdem ein integrierter Schaltkreis zur differentiellen Ansteuerung einer Laserdiode geschaffen, mit einem Signaleingang zum Empfang eines Datensignales; einem ersten Signalausgang zum Anschluss an die Anode der Laserdiode; einem zweiten Signalausgang zum Anschluss an die Kathode der Laserdiode; einem Modulator zur Modulation des Datensignales;einer mit der Kathode verbundenen Biasstromzufuhr; einem mit der Anode verbundenen Bezugspotential; einem ersten und einem zweiten Koppelkondensator zwischen einem ersten bzw. zweiten Ausgang des Modulators und dem ersten bzw. zweiten Signalausgang; und einer ersten und einer zweiten Kompensationsschaltung, die den ersten bzw. zweiten Koppelkondensatoren parallel geschaltet sind, wobei die ersten und zweiten Kompensationsschaltungen jeweils einen mit dem ersten bzw. zweiten Ausgang des Modulators verbundenen Tiefpass, der von einer das Datensignal führenden Schaltung angesteuerbar sein kann; und eine mit dem Tiefpass verbundenen Schaltung zur Erzeugung eines zur Tiefpassausgangsspannung umgekehrt proportionalen bzw. proportionalen Signales, das von dem Ausgangssignal abgezogen bzw. zum Ausgangssignal hinzuaddiert wird, aufweisen.

Je nach Ausgestaltung ist die Kathode von dem Bezugspotential induktiv getrennt, oder mit dem Bezugspotential intern gekoppelt. Ebenso kann die Anode von der Biasstromzufuhr induktiv getrennt, oder mit der Biasstromzufuhr intern gekoppelt sein.

Erfindungsgemäss ist weiterhin ein integrierter Schaltkreis zur Ansteuerung eines Laserdioden-Arrays mit einer Vielzahl von Laserdioden geschaffen, mit: einer Versorgungsspannungszufuhr; einem oder mehreren Signaleingängen zum Empfang von Datensignalen; einer Vielzahl von Signalausgängen zum Anschluss an die Laserdioden, wobei jeweils ein Signalausgang (in einfacher oder differentieller Ausführung) einer Laserdiode zugeordnet ist; einer Vielzahl von Modulationsstufen zur Modulation der Datensignale, wobei jeweils eine Modulationsstufe einem Signalausgang zugeordnet ist; und jeweils einem Koppelkondensator zwischen dem Ausgang eines der Modulationsstufen und dem zugeordneten Signalausgang, zur Bildung eines Hochpasses zusammen mit dem differentiellen Widerstand der zugeordneten Laserdiode.

Bei einem Betrieb eines Laserdioden-Arrays (Anordnung mehrerer Laserdioden mit einem mechanischen Verbund) durch eien Lasertreiber-IC mit mehrerer Modulationsausgängen ist die Verwendung integrierter Koppelkondensatoren besonders vorteilhaft. Bei Verwendung externer Koppelkapazitäten in bekannter Weise ist ein vergrösserter Leiterplattenaufbau notwendig. Die integrierte Koppelkapazität jeder Modulationsstufe macht dies jedoch unnötig.

Es ist somit möglich, die Modulationsausgänge des Lasertreiber-ICs direkt mit der Laserdiodenkoppeleinheit bzw. dem Laserdioden-Array zu verbinden, beispielsweise durch Bonddrähte.

In einer Ausgestaltung ist jedem Koppelkondensator eine aktive Kompensationsschaltung parallelgeschaltet mit: einem mit dem Ausgang der zugeordneten Modulationsstufe verbundenen Tiefpass; und einer mit dem Tiefpass verbundenen Schaltung zur Erzeugung eines zur Tiefpassausgangsspannung umgekehrt proportionalen Signales. Diese Schaltung ist derart mit dem jeweiligen Signalausgang verbunden, dass das zur Tiefpassausgangsspannung umgekehrt proportionale Signal vom jeweiligen Ausgangssignal abgezogen wird. Jeder Tiefpass kann von einer das jeweils zugeordnete Datensignal führenden Schaltung angesteuerbar sein.

In einer anderen Ausgestaltung ist jedem Koppelkondensator eine aktive Kompensationsschaltung parallelgeschaltet mit: einem mit dem Ausgang der zugeordneten Modulationsstufe verbundenen Tiefpass; und einer mit dem Tiefpass verbundenen Schaltung zur Erzeugung eines zur Tiefpassausgangsspannung proportionalen Signales. Diese Schaltung ist derart mit dem jeweiligen Signalausgang verbunden, dass das zur Tiefpassausgangsspannung proportionale Signal zum jeweiligen Ausgangssignal hinzuaddiert wird. Jeder Tiefpass kann von einer das jeweils zugeordnete Datensignal führenden Schaltung angesteuerbar sein.

In einer anderen Ausgestaltung ist jedem Koppelkondensator eine aktive Kompensationsschaltung parallelgeschaltet mit: einem mit dem Ausgang der zugeordneten Modulationsstufe verbundenen Tiefpass; einem mit dem Tiefpass verbundenen Spannungsinverter, zur Negierung der durch den Tiefpass entsprechend der Tiefpassübertragungsfunktion erzeugten Spannung; einen mit dem Ausgang des Spannungsinverters verbundenen Spannungsfolger; und einem Wandler zwischen dem Ausgang des Spannungsfolgers und.dem zugeordneten Signalausgang, zur Erzeugung eines zur Tiefpassausgangsspannung umgekehrt proportionalen Stromes.

Der erfindungsgemässe integrierte Schaltkreis kann in einem Lasertreiber-IC für eine 10Gbit/s-Datenübertragung zur Anwendung kommen, der einen VCSEL (Vertical Cavity Surface Emitting Laser) treibt und mit einer Versorgungsspannung von 3.3V arbeitet.

Weiterhin kann der erfindungsgemässe integrierte Schaltkreis in einem 10Gbit/s-Lasertreiber-IC mit mehreren Modulationsausgängen zur Anwendung kommen, der ein VCSEL-Array treibt und mit einer Versorgungsspannung von 3.3V arbeitet. Zum Vergleich: bekannte 10Gbit/s-Lasertreiber-ICs arbeiten nur mit Versorgungsspannungen 5V.

Anhand der Figuren werden beispielhafte Ausführungsformen des erfindungsgemäßen integrierten Schaltkreises dargestellt. Es zeigen dabei die
Figur 1 ein Prinzipschaltbild eines Ausführungsbeispieles der Erfindung;
Figur 2 ein Realisierungsbeispiel einer aktiven Kompensationsschaltung; .
Figur 3 ein Realisierungsbeispiel für einen Modulationsstromausgangstreiber;
Figur 4 ein Schaltbild nach einem ersten Kopplungsbeispiel von Lasertreiberausgang und Laserdiode;
Figur 5 ein Schaltbild nach einem zweiten Kopplungsbeispiel von Lasertreiberausgang und Laserdiode; und
Figur 6 ein Schaltbild nach einem dritten Kopplungsbeispiel von Lasertreiberausgang und Laserdiode.

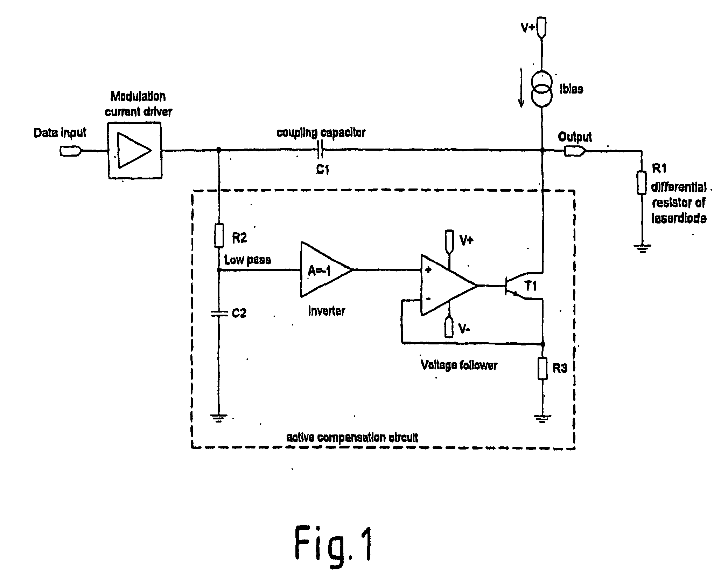

Figur 1 zeigt ein Prinzipschaltbild eines Ausführungsbeispieles der Erfindung, mit einer aktiven Kompensationsschaltung zur Aufweitung der unteren Bandbreitenbegrenzung des Hochpasses. Der Hochpass am Modulationsstromtreiberausgang wird gebildet durch die integrierte Koppelkapazität C1 und den differentiellen Widerstand R1 der Laserdiode. C1 und R1 bilden die Zeitkonstante τ1 = R1*C1.

Die in Figur 1 dargestellte aktive Kompensationsschaltung besteht aus einem Tiefpass, einem Spannungsinverter, und einem Spannungsfolger mit anschliessender Spannungs-Strom-Wandlung. Der Wirkungsmechanismus ist folgender: Der Tiefpass, bestehend aus R2 und C2, filtert entsprechend seiner Zeitkonstante τ2 = R2*C2 die hohen Frequenzen aus dem Datensignal heraus. Entsprechend der Tiefpassübertragungsfunktion entsteht eine Ausgangsspannung, die mit Hilfe des Inverters negiert wird. Aus dem Inverterausgangssignal wird durch den Spannungsfolger mit anschliessender Spannungs-Strom-Wandlung an R3 ein zum Tiefpassausgangssignal umgekehrt proportionaler Strom erzeugt. Dieser Ausgangsstrom der Kompensationsschaltung wird dem durch C1 fliessenden Ausgangsstrom abgezogen. Bei geeigneter Wahl der Grössen von R2, C2 und R3 kompensiert der Ausgangsstrom der Kompensationsschaltung den bandbegrenzenden Einfluss des Hochpasses (R1, C1) auf die unteren Frequenzteile das Datensignals; d.h. die nach dem Kondensator C1 fehlenden Signale (Frequenzanteile fgl < 1/(2πτ1)) werden durch die aktive Kompensationsschaltung wieder hinzugefügt.

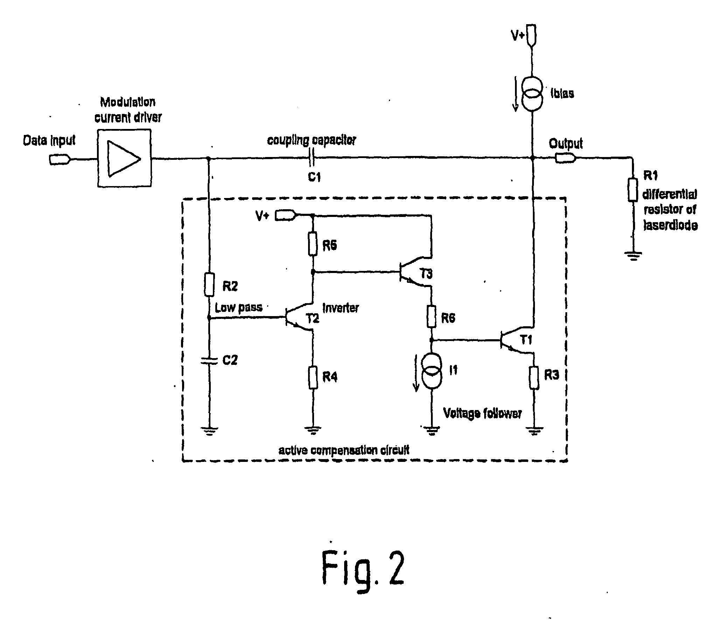

Figur 2 zeigt ein Realisierungsbeispiel der aktiven Kompensationsschaltung (hier mit einem Single-Ended-Ausgangstreiber) zur Aufweitung der unteren Bandbreitenbegrenzung des aus C1 und R1 gebildeten Hochpasses. Der Tiefpass besteht aus R2 und C2. Der Inverter ist durch die Emitterschaltung T2, R4 und R5 realisiert. Der Spannungsfolger mit anschliessender Spannungs-Strom-Wandlung besteht aus den Elementen T3, R6, I1, T1 und R3.

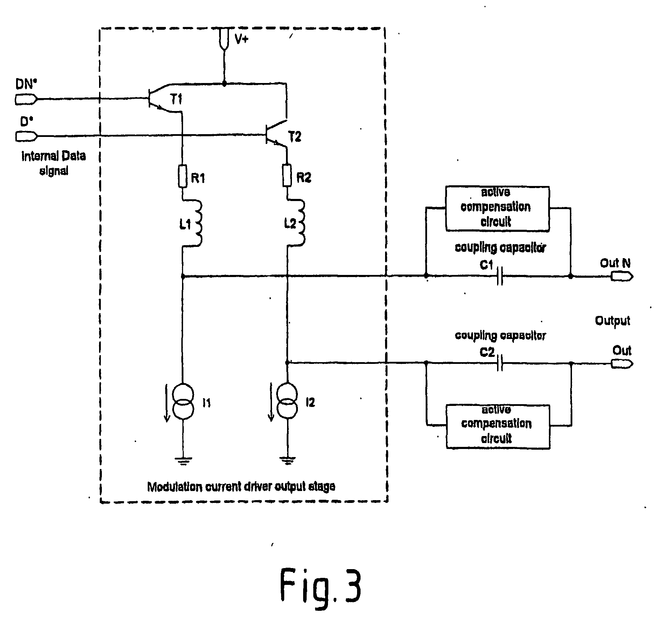

Figur 3 zeigt eine Realisierungsbeispiel des Modulationsausgangtreibers (hier als differentielle Schaltung). T1 und T2 arbeiten in Kollektorschaltung auf die integrierten Koppelkapazitäten C1 und C2. Die Widerstände R1 und R2 arbeiten als Dämpfungswiderstände. L1 und L2 dienen zur Kompensation von parasitären Kapazitäten. Die aktiven Kompensationsschaltungen sind den integrierten Koppelkapazitäten parallel geschaltet.

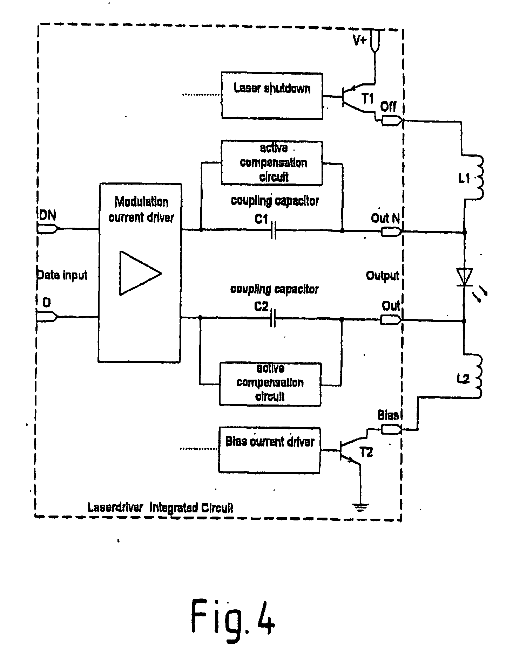

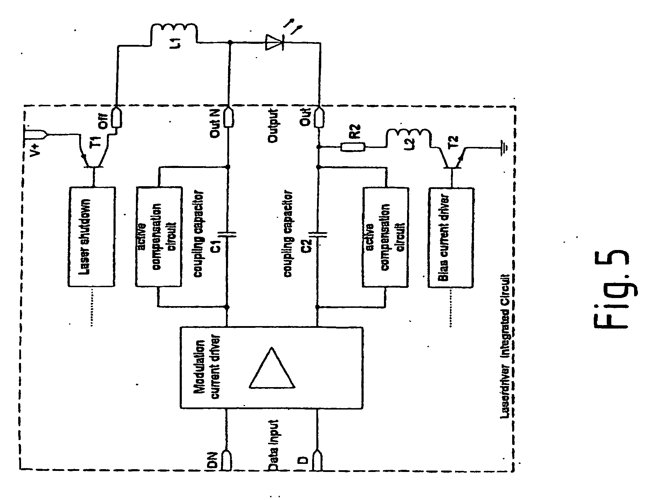

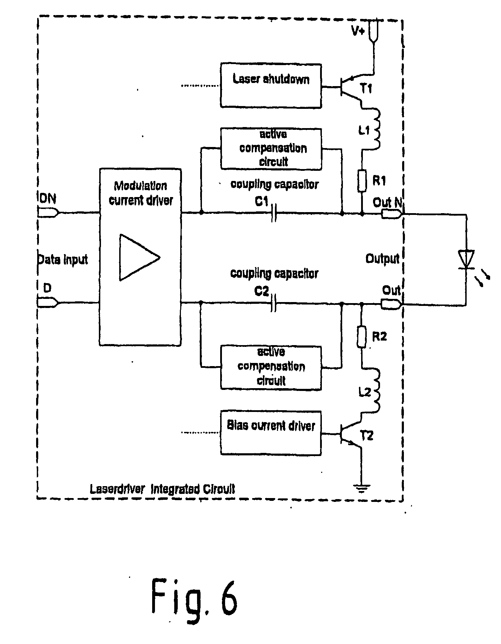

Die Figuren 4 bis 6 zeigen die Anwendung der aktiven Kompensationsschaltung in verschiedenen Kopplungsformen für den Lasertreiberausgang und die Laserdiode. Figur 4 zeigt eine differentielle Ansteuerung der Laserdiode bei induktiver Trennung von der Biasstromzufuhr und dem Bezugspotential. Figur 5 zeigt eine differentielle Ansteuerung der Laserdiode bei interner Biasstromzufuhr und induktiver Trennung vom Bezugspotential. Figur 6 zeigt ebenfalls eine differentielle Ansteuerung der Laserdiode bei interner Kopplung an die Biasstromzufuhr und an das Bezugspotential.

Es ist anzumerken, dass die Erfindung nicht auf die beschriebenen Ausführungsbeispiele beschränkt ist, sondern Modifikationen innerhalb des durch die Ansprüche definierten Schutzbereiches umfasst.

## Patentansprüche

1. Integrierter Schaltkreis zur Ansteuerung einer Laserdiode, mit:
einem Signaleingang zum Empfang eines Datensignales;
einem Signalausgang zum Anschluss an die Laserdiode;
einem Modulator zur Modulation des Datensignales;
einer mit dem Signalausgang verbundenen Stromeinspeisung zur Biasstromzufuhr; **dadurch gekennzeichnet, daß** der integrierte Schaltkreis des weiteren einen Koppelkondensator zwischen dem Ausgang des Modulators und dem Signalausgang, zur Bildung eines Hochpasses mit dem differentiellen Widerstand der an den Signalausgang angeschlossenen Laserdiode umfaßt.

2. Integrierter Schaltkreis nach Anspruch 1, mit einer aktiven Kompensationsschaltung mit:
einem mit dem Ausgang des Modulators verbundenen Tiefpass; und
einer mit dem Tiefpass verbundenen Schaltung zur Erzeugung eines zur Tiefpassausgangsspannung umgekehrt proportionalen Signales, das vom Ausgangssignal abgezogen wird.

3. Integrierter Schaltkreis nach Anspruch 1, mit einer aktiven Kompensationsschaltung mit:
einem mit dem Ausgang des Modulators verbundenen Tiefpass; und
einer mit dem Tiefpass verbundenen Schaltung zur Erzeugung eines zur Tiefpassausgangsspannung proportionalen Signales, das zum Ausgangssignal addiert wird.

4. Integrierter Schaltkreis nach Anspruch 2 oder 3, wobei der Tiefpass von einer das Datensignal führenden Schaltung angesteuert wird.

5. Integrierter Schaltkreis nach Anspruch 1, mit einer aktiven Kompensationsschaltung mit:
einem mit dem Ausgang des Modulators verbundenen Tiefpass; einem mit dem Tiefpass verbundenen Spannungsinverter, zur Negierung der durch den Tiefpass entsprechend der Tiefpassübertragungsfunktion erzeugten Spannung;
einen mit dem Ausgang des Spannungsinverters verbundenen Spannungsfolger; und
einem Wandler zwischen dem Ausgang des Spannungsfolgers und dem Signalausgang, zur Erzeugung eines zur Tiefpassausgangsspannung umgekehrt proportionalen Stromes.

6. Integrierter Schaltkreis nach einem der vorhergehenden Ansprüche, wobei die Versorgungsspannung im wesentlichen 3.3V beträgt.

7. Integrierter Schaltkreis zur differentiellen Ansteuerung einer Laserdiode, mit
einem Signaleingang zum Empfang eines Datensignales;
einem ersten Signalausgang zum Anschluss an die Anode der Laserdiode;
einem zweiten Signalausgang zum Anschluss an die Kathode der Laserdiode;
einem Modulator zur Modulation des Datensignales;
einer mit der Kathode verbundenen Biasstromzufuhr;
einem mit der Anode verbundenen Bezugspotential;
einem ersten und einem zweiten Koppelkondensator zwischen einem ersten bzw. zweiten Ausgang des Modulators und dem ersten bzw. zweiten Signalausgang; und
einer ersten und einer zweiten Kompensationsschaltung, die den ersten bzw. zweiten Koppelkondensatoren parallel geschaltet sind, wobei die ersten und zweiten Kompensationsschaltungen jeweils einen mit dem ersten bzw. zweiten Ausgang des Modulators verbundenen Tiefpass, der von einer das Datensignal führenden Schaltung angesteuerbar sein kann; und eine mit dem Tiefpass verbundenen Schaltung zur Erzeugung eines zur Tiefpassausgangsspannung umgekehrt proportionalen bzw. proportionalen Signales, das von dem Ausgangssignal abgezogen bzw. zum Ausgangssignal hinzuaddiert wird, aufweisen.

8. Integrierter Schaltkreis nach Anspruch 7, wobei die ersten und zweiten Kompensationsschaltungen jeweils einen mit dem ersten bzw. zweiten Ausgang des Modulators verbundenen Tiefpass; einen mit dem Tiefpass verbundenen Spannungsinverter zur Negierung der durch den Tiefpass entsprechend der Tiefpassübertragungsfunktion erzeugten Spannung; einen mit dem Ausgang des Spannungsinverters verbundenen Spannungsfolger; und einen Wandler zwischen dem Ausgang des Spannungsfolgers und dem ersten bzw. zweiten Signalausgang zur Erzeugung eines zur Tiefpassausgangsspannung umgekehrt proportionalen Stromes, aufweisen.

9. Integrierter Schaltkreis nach Anspruch 7 oder 8, wobei die Kathode von dem Bezugspotential induktiv getrennt ist.

10. Integrierter Schaltkreis nach Anspruch 7 oder 8, wobei die Kathode und das Bezugspotential intern gekoppelt sind.

11. Integrierter Schaltkreis nach einem der Ansprüche 7 bis 10, wobei die Anode von der Biasstromzufuhr induktiv getrennt ist.

12. Integrierter Schaltkreis nach einem der Ansprüche 7 bis 10, wobei die Anode und die Biasstromzufuhr intern gekoppelt sind.

13. Integrierter Schaltkreis nach einem der vorhergehenden Ansprüche, wobei die Laserdiode durch ein VCSEL gebildet ist.

14. Integrierter Schaltkreis zur Ansteuerung eines Laserdioden-Arrays mit einer Vielzahl von Laserdioden, mit:
einer Versorgungsspannungszufuhr;
einem oder mehreren Signaleingängen zum Empfang von Datensignalen;
einer Vielzahl von Signalausgängen zum Anschluss an die Laserdioden, wobei jeweils ein Signalausgang einer Laserdiode zugeordnet ist;
einer Vielzahl von Modulationsstufen zur Modulation der Datensignale, wobei jeweils eine Modulationsstufe einem Signalausgang zugeordnet ist; und
jeweils einem Koppelkondensator zwischen dem Ausgang eines der Modulationsstufen und dem zugeordneten Signalausgang, zur Bildung eines Hochpasses zusammen mit dem differentiellen Widerstand der zugeordneten Laserdiode.

15. Integrierter Schaltkreis nach Anspruch 14, wobei jedem Koppelkondensator eine aktive Kompensationsschaltung parallelgeschaltet ist mit:
einem mit dem Ausgang der zugeordneten Modulationsstufe verbundenen Tiefpass; und
einer mit dem Tiefpass verbundenen Schaltung zur Erzeugung eines zur Tiefpassausgangsspannung umgekehrt proportionalen Signales, das vom Ausgangssignal abgezogen wird.

16. Integrierter Schaltkreis nach Anspruch 14, wobei jedem Koppelkondensator eine aktive Kompensationsschaltung parallelgeschaltet ist mit:
einem mit dem Ausgang der zugeordneten Modulationsstufe verbundenen Tiefpass; und
einer mit dem Tiefpass verbundenen Schaltung zur Erzeugung eines zur Tiefpassausgangsspannung proportionalen Signales, das zum Ausgangssignal addiert wird.

17. Integrierter Schaltkreis nach Anspruch 15 oder 16, wobei der Tiefpass von einer das Datensignal führenden Schaltung angesteuert wird.

18. Integrierter Schaltkreis nach Anspruch 14, wobei jedem Koppelkondensator eine aktive Kompensationsschaltung parallelgeschaltet ist mit:
einem mit dem Ausgang der zugeordneten Modulationsstufe verbundenen Tiefpass;
einem mit dem Tiefpass verbundenen Spannungsinverter, zur Negierung der durch den Tiefpass entsprechend der Tiefpassübertragungsfunktion erzeugten Spannung;
einen mit dem Ausgang des Spannungsinverters verbundenen Spannungsfolger; und
einem Wandler zwischen dem Ausgang des Spannungsfolgers und dem zugeordneten Signalausgang, zur Erzeugung eines zur Tiefpassausgangsspannung umgekehrt proportionalen Stromes.

19. Integrierter Schaltkreis nach einem der Ansprüche 14 bis 18, wobei die Laserdioden durch VCSELs gebildet sind.

20. Integrierter Schaltkreis nach einem der Ansprüche 14 bis 19, wobei die Versorgungsspannung im wesentlichen 3.3V beträgt.

## Claims

1. Integrated circuit for controlling a laser diode, having:
a signal input for receiving a data signal;
a signal output for connection to the laser diode;
a modulator for modulation of the data signal;
a current infeed connected to the signal output and serving for the supply of a bias current; **characterized in that** the integrated circuit furthermore comprises a coupling capacitor between the output of the modulator and the signal output, for forming a high-pass filter with the differential resistor of the laser diode connected to the signal output.

2. Integrated circuit according to Claim 1, having an active compensation circuit having:
a low-pass filter connected to the output of the modulator; and
a circuit connected to the low-pass filter and serving for generating a signal which is inversely proportional to the low-pass filter output voltage, which signal is subtracted from the output signal.

3. Integrated circuit according to Claim 1, having an active compensation circuit having:
a low-pass filter connected to the output of the modulator; and
a circuit connected to the low-pass filter and serving for generating a signal which is proportional to the low-pass filter output voltage, which signal is added to the output signal.

4. Integrated circuit according to Claim 2 or 3, the low-pass filter being controlled by a circuit carrying the data signal.

5. Integrated circuit according to Claim 1, having an active compensation circuit having:
a low-pass filter connected to the output of the modulator,
a voltage inverter connected to the low-pass filter and
serving for inverting the voltage generated by the low-pass filter in accordance with the low-pass filter transfer function;
a voltage follower connected to the output of the voltage inverter; and
a converter between the output of the voltage follower and the signal output, for generating a current which is inversely proportional to the low-pass filter output voltage.

6. Integrated circuit according to one of the preceding claims, the supply voltage essentially being 3.3V.

7. Integrated circuit for differentially controlling a laser diode, having
a signal input for receiving a data signal;
a first signal output for connection to the anode of the laser diode;
a second signal output for connection to the cathode of the laser diode;
a modulator for modulating the data signal;
a bias current supply connected to the cathode;
a reference-earth potential connected to the anode;
a first and a second coupling capacitor between a first and second output, respectively of the modulator and the first and second signal output, respectively; and
a first and a second compensation circuit connected in parallel with the first and second coupling capacitors, respectively, the first and second compensation circuits in each case having a low-pass filter, which is connected to the first and second output, respectively, of the modulator and can be controlled by a circuit carrying the data signal; and a circuit connected to the low-pass filter and serving for generating a signal which is inversely proportional and proportional, respectively, to the low-pass filter output voltage, which signal is subtracted from the output signal and, respectively, added to the output signal.

8. Integrated circuit according to Claim 7, the first and second compensation circuits in each case having a low-pass filter connected to the first and second output, respectively, of the modulator; a voltage inverter connected to the low-pass filter and serving for inverting the voltage generated by the low-pass filter in accordance with the low-pass filter transfer function; a voltage follower connected to the output of the voltage inverter; and a converter between the output of the voltage follower and the first and second signal output, especially, for generating a current which is inversely proportional to the low-pass filter output voltage.

9. Integrated circuit according to Claim 7 or 8, the cathode being inductively isolated from the reference-earth potential.

10. Integrated circuit according to Claim 7 or 8, the cathode and the reference-earth potential being internally coupled.

11. Integrated circuit according to one of Claims 7 to 10, the anode being inductively isolated from the bias current supply.

12. Integrated circuit according to one of Claims 7 to 10, the anode and the bias current supply being internally coupled.

13. Integrated circuit according to one of the preceding claims, the laser diode being formed by a VCSEL.

14. Integrated circuit for controlling a laser diode array having a multiplicity of laser diodes, having;
a supply voltage feed;
one or a plurality of signal inputs for receiving data signals;
a multiplicity of signal outputs for connection to the laser diodes, a signal output in each case being assigned to a laser diode;
a multiplicity of modulation stages for modulating the data signals, a modulation stage in each case being assigned to a signal output; and
a respective coupling capacitor between the output of one of the modulation stages and the assigned signal output, for the formation of a high-pass filter together with the differential resistor of the assigned laser diode.

15. Integrated circuit according to Claim 14, an active compensation circuit being connected in parallel with each coupling capacitor, having:
a low-pass filter connected to the output of the assigned modulation stage; and
a circuit connected to the low-pass filter and serving for generating a signal which is inversely proportional to the low-pass filter and serving for generating a signal which is inversely proportional to the low-pass filter output voltage, which signal is subtracted from the output signal.

16. Integrated circuit according to Claim 14, an active compensation circuit being connected in parallel with each coupling capacitor, having:
a low-pass filter connected to the output of the assigned modulation stage; and
a circuit connected to the low-pass filter and serving for generating a signal which is proportional to the low-pass filter and serving for generating a signal which is inversely proportional to the low-pass filter output voltage, which signal is added to the output signal.

17. Integrated circuit according to Claim 15 or 16, the low-pass filter being controlled by a circuit carrying the data signal.

18. Integrated circuit according to Claim 14, an active compensation circuit being connected in parallel with each coupling capacitor, having:
a low-pass filter connected to the output of the assigned modulation stage;
a voltage inverter connected to the low-pass filter and serving for inverting the voltage generated by the low-pass filter in accordance with the low-pass filter transfer function;
a voltage follower connected to the output of the voltage inverter; and
a converter between the output of the voltage follower and the assigned signal output, for generating a current which is inversely proportional to the low-pass filter output voltage.

19. Integrated circuit according to one of Claims 14 to 18, the laser diodes being formed by VCSELs.

20. Integrated circuit according to one of Claims 14 to 19, the supply voltage essentially being 3.3 V.

## Revendications

1. Circuit intégré de commande d'une diode laser comprenant :
une entrée de signal pour recevoir un signal de données ;
une sortie de signal pour le raccordement à la diode laser ;
un modulateur de modulation du signal de données ;
une alimentation en courant reliée à la sortie du signal pour envoyer du courant polarisé,
**caractérisé en ce que** le circuit intégré comprend, en outre, un condensateur de couplage entre la sortie du modulateur et la sortie du signal pour la formation d'un passe-haut avec la résistance différentielle de la diode laser raccordée à la sortie du signal.

2. Circuit intégré suivant la revendication 1, comprenant un circuit actif de compensation comprenant :
un passe-bas relié à la sortie du modulateur ; et
un circuit relié au passe-bas de production d'un signal inversement proportionnel à la tension de sortie du passe-bas et soustrait du signal de sortie.

3. Circuit intégré suivant la revendication 1 comprenant un circuit actif de compensation comprenant :
un passe-bas relié à la sortie du modulateur ; et
un circuit relié au passe-bas de production d'un signal proportionnel à la tension de sortie du passe-bas et ajouté au signal de sortie.

4. Circuit intégré suivant la revendication 2 ou 3, dans lequel le passe-bas est commandé par un circuit acheminant le signal de données.

5. Circuit intégré suivant la revendication 1, comprenant un circuit actif de compensation comprenant :
un passe-bas relié à la sortie du modulateur ;
un inverseur de tension relié au passe-bas pour inverser la tension produite par le passe-bas et correspondant à la fonction de transfert du passe-bas ;
un suiveur de tension relié à la sortie de l'inverseur de tension ; et
un convertisseur entre la sortie du suiveur de tension et la sortie du signal pour la production d'un courant inversement proportionnel à la tension de sortie du passe-bas.

6. Circuit intégré suivant l'une des revendications précédentes, dans lequel la tension d'alimentation est sensiblement de 3,3 V.

7. Circuit intégré de commande différentielle d'une diode laser comprenant :
une entrée de signal pour la réception d'un signal de données ;
une première sortie de signal pour le raccordement à l'anode de la diode laser ;
une deuxième sortie de signal pour le raccordement à la cathode de la diode laser ;
un modulateur de modulation du signal de données ;
une entrée de courant de polarisation reliée à la cathode ;
un potentiel de référence relié à l'anode ;
un premier et un deuxième condensateurs de couplage entre une première et une deuxième sorties du modulateur et la première et la deuxième sorties du signal ; et
un premier et un deuxième circuits de compensation qui sont montés en parallèle avec les premier et deuxième condensateurs de couplage, les premier et deuxième circuits de compensation ayant, respectivement, un passe-bas relié à la première et à la deuxième sorties du modulateur et pouvant être commandés par un circuit acheminant le signal de données ; et un circuit relié au passe-bas de production d'un signal proportionnel ou inversement proportionnel à la tension de sortie du passe-bas et soustrait du signal de sortie ou ajouté au signal de sortie.

8. Circuit intégré suivant la revendication 7, dans lequel les premier et deuxième circuits de compensation ont, respectivement, un passe-bas relié aux premier et deuxième modulateurs ; un inverseur de tension relié au passe-bas pour inverser la tension produite par le passe-bas conformément à la fonction de transfert du passe-bas ; un suiveur de tension relié à la sortie de l'inverseur de tension ; et un convertisseur entre la sortie du suiveur de tension et la première et la deuxième sorties du signal pour la production d'un courant inversement proportionnel à la tension de sortie du passe-bas.

9. Circuit intégré suivant la revendication 7 ou 8, dans lequel la cathode est séparée inductivement du potentiel de référence.

10. Circuit intégré suivant la revendication 7 où 8, dans lequel la cathode et le potentiel de référence sont couplés d'une manière interne.

11. Circuit intégré suivant l'une des revendications 7 à 10, dans lequel l'anode est séparée inductivement de l'entrée de courant de polarisation.

12. Circuit intégré suivant l'une des revendications 7 à 10, dans lequel l'anode et l'entrée de courant de polarisation sont couplées d'une manière interne.

13. Circuit intégré suivant l'une des revendications précédentes, dans lequel la diode laser est formée par un VCSEL.

14. Circuit intégré de commande d'un réseau de diodes lasers ayant une pluralité de diodes lasers et comprenant :
une entrée de tension d'alimentation ;
une ou plusieurs entrées de signal pour la réception de signaux de données ;
une pluralité de sorties de signal pour le raccordement aux diodes lasers, une sortie de signal étant associée, respectivement, à une diode laser ;
une pluralité d'étages de modulation pour la modulation des signaux de données, un étage de modulation étant associé, respectivement, à une sortie de signal ; et
respectivement, un condensateur de couplage entre la sortie de l'un des étages de modulation et la sortie associée du signal pour la formation d'un passe-haut, ensemble avec la résistance différentielle de la diode laser associée.

15. Circuit intégré suivant la revendication 14, dans lequel il est monté en parallèle à chaque condensateur de couplage un circuit actif de compensation comprenant :
un passe-bas relié à la sortie de l'étage de modulation associé ;
un circuit relié au passe-bas de production d'un signal inversement proportionnel à la tension de sortie du passe-bas et déduit du signal de sortie.

16. Circuit intégré suivant la revendication 14, dans lequel il est monté en parallèle à chaque condensateur de couplage un circuit actif de condensation comprenant :
un passe-bas relié à la sortie de l'étage de modulation associé ; et
un circuit relié au passe-bas de production d'un signal proportionnel à la tension de sortie du passe-bas et ajouté au signal de sortie.

17. Circuit intégré suivant la revendication 15 ou 16, dans lequel le passe-bas est commandé par un circuit acheminant le signal de données.

18. Circuit intégré suivant la revendication 14, dans lequel il est monté en parallèle à chaque condensateur de couplage un circuit actif de compensation comprenant :
un passe-bas relié à la sortie de l'étage de modulation associé ;
un inverseur de tension relié au passe-bas pour inverser la tension produite par le passe-bas conformément à la fonction de transfert du passe-bas ;
un suiveur de tension relié à la sortie de l'inverseur de tension ; et
un convertisseur entre la sortie du suiveur de tension et la sortie du signal associée de production d'un courant inversement proportionnel à la tension de sortie du passe-bas.

19. Circuit intégré suivant l'une des revendications 14 à 18, dans lequel les diodes lasers sont formées par des VCSEL.

20. Circuit intégré suivant l'une des revendications 14 à 19, dans lequel la tension d'alimentation est sensiblement égale à 3,3 V.
